# EUROPÄISCHE PATENTANMELDUNG

(11) **EP 0 768 796 A1**
(43) Veröffentlichungstag der Anmeldung: **16.04.1997**
(21) Anmeldenummer: 96202756.1
(22) Anmeldetag: 03.10.1996
(51) Int. Cl.: H04N 5/775, H03K 17/74

(54) **Schaltungsanordnung zum Einspeisen eines Antennensignals**

(30) Priorität: 13.10.1995 DE 19538172
(71) Anmelder: Philips Patentverwaltung GmbH, 22335 Hamburg (DE); PHILIPS ELECTRONICS N.V., 5621 BA Eindhoven (NL)
(72) Erfinder: Ruitenburg, Leo, 6071 GP Swalmen (NL)
(74) Vertreter: Peters, Carl Heinrich, Dipl.-Ing.

(57) **Zusammenfassung**

Beschrieben wird eine Schaltungsanordnung zum Einspeisen eines Antennensignals an eine Empfangsanordnung eines Videorecorders und/oder einen an diesen angeschlossenen Fernsehempfänger mit einer Schaltvorrichtung, wobei im gesperrten Zustand der Schaltvorrichtung das Antennensignal nur der Empfangsanordnung des Videorecorders zuführbar und von dieser an den Fernsehempfänger weiterleitbar ist und im leitenden Zustand der Schaltvorrichtung das Antennensignal über diese unmittelbar dem Fernsehempfänger zuführbar ist, sowie eine Schaltvorrichtung hierfür.

Um unerwünscht niedrige Impedanzen am Eingang bzw. am Ausgang zu vermeiden, wird vorgeschlagen, daß
- die Schaltvorrichtung eine Reihenschaltung aus nacheinander einem ersten kapazitiven Schaltelement (3) mit konstanter Kapazität, wenigstens einem Paar zweiter kapazitiver Schaltelemente (4-7) und einem dritten kapazitiven Schaltelement (8) mit konstanter Kapazität enthält, wobei die zweiten kapazitiven Schaltelemente (4-7) innerhalb der Paare zueinander in Reihe angeordnet sind, das erste kapazitive Schaltelement (3) mit einem Eingang zum Zuführen des Antennensignals zur Schaltvorrichtung und das dritte kapazitive Schaltelement (8) mit einem Ausgang zum Abgeben des Antennensignals von der Schaltvorrichtung verbunden ist,
- zum Überführen der Schaltvorrichtung in den gesperrten Zustand den Verbindungen (16,17) der zweiten Schaltelemente (4-7) innerhalb der Paare ein niedriges Potential (20) und den Verbindungen (13-15) der Paare untereinander bzw. mit dem ersten (3) bzw. dritten (8) kapazitiven Schaltelement ein hohes Potential (12) zuleitbar ist,
- in wenigstens einem der Paare wenigstens eines (6) der zweiten kapazitiven Schaltelemente (4-7) eine konstante Kapazität aufweist und die übrigen (4,5,7) zweiten kapazitiven Schaltelemente als Kapazitätsdioden ausgebildet sind, die mit ihren Anoden an die Verbindungen (16,17) innerhalb der Paare und mit ihren Kathoden an die Verbindungen (13-15) der Paare untereinander angeschlossen sind,
- und mit dem ersten (3) und mit dem dritten (8) kapazitiven Schaltelement je eines (4,7) der als Kapazitätsdioden ausgebildeten zweiten kapazitiven Schaltelemente (4,5,7) verbunden ist.

## Beschreibung

Die Erfindung bezieht sich auf eine Schaltungsanordnung zum Einspeisen eines Antennensignals an eine Empfangsanordnung eines Videorecorders und/oder einen an diesen angeschlossenen Fernsehempfänger mit einer Schaltvorrichtung, wobei im gesperrten Zustand der Schaltvorrichtung das Antennensignal nur der Empfangsanordnung des Videorecorders zuführbar und von dieser an den Fernsehempfänger weiterleitbar ist und im leitenden Zustand der Schaltvorrichtung das Antennensignal über diese unmittelbar dem Fernsehempfänger zuführbar ist, sowie auf eine Schaltvorrichtung, die in ihrem gesperrten Zustand die Weiterleitung eines Antennensignals unterbricht und die Weiterleitung des Antennensignals in ihrem leitenden Zustand gestattet.

Eine derartige Schaltungsanordnung und eine Schaltvorrichtung hierfür sind in der europäischen Patentanmeldung 95 200 962.9 beschrieben. Die dortige Schaltvorrichtung umfaßt bevorzugt eine Reihenschaltung aus wenigstens zwei Kapazitätsdioden, die abwechselnd in entgegengesetzter Polung aufgereiht sind. Die Kathode der ersten Kapazitätsdiode in dieser Reihenschaltung ist über einen ersten Koppelkondensator mit einem Antenneneingang verbunden. Bei entsprechenden Anzahl der Kapazitätsdioden in der Reihenschaltung kann ferner der Fall eintreten, daß die Anode der letzten Kapazitätsdiode der Reihenschaltung über einen zweiten Koppelkondensator mit einem Antennenausgang verbunden ist. In diesem Fall wird im gesperrten Zustand der Schaltvorrichtung vom Antennenausgang über den zweiten Koppelkondensator eine niederohmige Verbindung an Masse geschaffen. Diese kann zu einer Fehlanpassung des Wellenwiderstands einer mit dem Antennenausgang verbundenen Leiteranordnung führen.

Die Erfindung hat die Aufgabe, eine Schaltungsanordnung und eine zugehörige Schaltvorrichtung der eingangs genannten Art in der Weise zu verbessern, daß die beschriebene Fehlanpassung vermieden wird.

Diese Aufgabe wird bei einer Schaltungsanordnung und zugehörigen Schaltvorrichtung der gattungsgemäßen Art erfindungsgemäß dadurch gelöst, daß
- die Schaltvorrichtung eine Reihenschaltung aus nacheinander einem ersten kapazitiven Schaltelement mit konstanter Kapazität, wenigstens einem Paar zweiter kapazitiver Schaltelemente und einem dritten kapazitiven Schaltelement mit konstanter Kapazität enthält, wobei die zweiten kapazitiven Schaltelemente innerhalb der Paare zueinander in Reihe angeordnet sind, das erste kapazitive Schaltelement mit einem Eingang zum Zuführen des Antennensignals zur Schaltvorrichtung und das dritte kapazitive Schaltelement mit einem Ausgang zum Abgeben des Antennensignals von der Schaltvorrichtung verbunden ist,
- zum Überführen der Schaltvorrichtung in den gesperrten Zustand den Verbindungen der zweiten Schaltelemente innerhalb der Paare ein niedriges Potential und den Verbindungen der Paare untereinander bzw. mit dem ersten bzw. dritten kapazitiven Schaltelement ein hohes Potential zuleitbar ist,
- in wenigstens einem der Paare wenigstens eines der zweiten kapazitiven Schaltelemente eine konstante Kapazität aufweist und die übrigen zweiten kapazitiven Schaltelemente als Kapazitätsdioden ausgebildet sind, die mit ihren Anoden an die Verbindungen innerhalb der Paare und mit ihren Kathoden an die Verbindungen der Paare untereinander angeschlossen sind,
- und mit dem ersten und mit dem dritten kapazitiven Schaltelement je eines der als Kapazitätsdioden ausgebildeten zweiten kapazitiven Schaltelemente verbunden ist.

In der der Erfindung gemäßen Schaltungvorrichtung ist somit wenigstens ein Paar zueinander in Reihe angeordneter, kapazitiver Schaltelemente vorhanden. Sind mehrere Paare derartiger Schaltelemente vorhanden, werden die einzelnen Paare zueinander in Reihe angeordnet und ist die so gebildete Reihenschaltung an ihrem Anfang und ihrem Ende in Reihe mit dem ersten bzw. dritten kapazitiven Schaltelement angeordnet. Die zweiten kapazitiven Schaltelemente können bis auf das erste und das letzte der zweiten kapazitiven Schaltelemente in der Reihenschaltung aller zweiten kapazitiven Schaltelemente wahlweise mit konstanter oder variabler Kapazität, d.h. im letzten Fall als Kapazitätsdioden, ausgeführt sein. Damit wird erreicht, daß im gesperrten Zustand der Schaltvorrichtung zwischen dem Eingang der Schaltvorrichtung und Masse bzw. dem Ausgang der Schaltvorrichtung und Masse stets ein dann hochohmiges kapazitives Schaltelement angeordnet ist. Dadurch wird der beschriebene niederohmige Abschluß vermieden.

In der Zeichnung, in der übereinstimmende Elemente mit identischen Bezugszeichen versehen sind, sind zwei Ausführungsbeispiele einer Schaltvorrichtung nach der Erfindugn dargestellt.

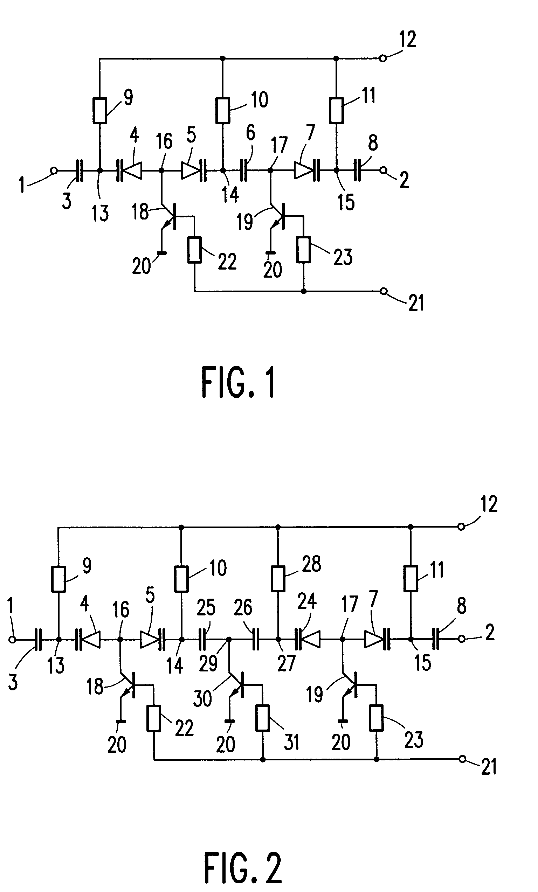

Im ersten Ausführungsbeispiel für die Gestaltung der Schaltvorrichtung gemäß Fig. 1 ist zwischen einem Eingang 1, der beispielsweise durch einen Antenneneingang eines Videorecorders gebildet sein kann, und einem Ausgang 2, der beispielsweise durch einen Antennenausgang des Videorecorders gebildet sein kann, eine Reihenschaltung aus einem ersten Koppelkondensator 3, einer ersten und einer zweiten Kapazitätsdiode 4 bzw. 5, einem Kondensator 6, einer dritten Kapazitätsdiode 7 und einem zweiten Koppelkondensator 8 angeordnet. Dabei bildet der erste Koppelkondensator 3 das erste kapazitive Schaltelement, die Kapazitätsdioden 4, 5, 7 und der Kondensator 6 die zweiten kapazitiven Schaltelemente und der zweite Koppelkondensator 8 das dritte kapazitive Schaltelement. Innerhalb der zweiten kapazitiven Schaltelemente bilden die erste und die zweite Kapazitätsdiode 4, 5 das erste Paar und der Kondensator 6 und die dritte Kapazitätsdiode 7 das zweite Paar.

Die Verbindungen zwischen dem ersten Koppelkondensator 3, dem aus der ersten und der zweiten Kapazitätsdiode 4, 5 gebildeten ersten Paar zweiter kapazitiver Schaltelemente, dem aus dem Kondensator 6 und der dritten Kapazitätsdiode 7 gebildeten zweiten Paar zweiter kapazitiver Schaltelemente und dem zweiten Koppelkondensator 8 sind über je einen Vorwiderstand 9, 10 bzw. 11 mit einem ersten Steueranschluß 12 verbunden. Diese Verbindungen zwischen den kapazitiven Schaltelementen sind in Fig. 1 mit den Bezugszeichen 13, 14, 15 versehen. Die Verbindungen der zweiten Schaltelemente innerhalb der Paare - Kapazitätsdioden 4, 5 bzw. Kondensator 6 und Kapazitätsdiode 7 - sind mit den Bezugszeichen 16 und 17 versehen und über je einen Schalttransistor 18 bzw. 19 mit Masse 20 verbunden. Mit dem Basisanschluß dieser Schalttransistoren 18, 19 ist ein zweiter Steueranschluß 21 über je einen Basiswiderstand 22 bzw. 23 verbunden.

Die Steueranschlüsse 12, 21 erhalten Schaltspannungen zugeführt. Beispielsweise wird als Schaltspannung für den ersten Steueranschluß 12 im gesperrten Zustand der Schaltvorrichtung ein (Gleich-)Potential von 33 V verwendet, wohingegen an den zweiten Steueranschluß 21 als Schaltspannung ein Potential von 5 V angelegt werden kann. Durch entsprechende Dimensionierung der Basiswiderstände 22, 23 und der Vorwiderstände 9, 10, 11 sowie der Kapazitätsdioden 4, 5, 7, des Kondensators 6 und der Schalttransistoren 18, 19 können jedoch auch andere, vorzugsweise auch übereinstimmende Potentiale, zur Anwendung gelangen. Bei anliegenden Schaltspannungen werden die Anoden der Kapazitätsdioden 4, 5, 7 mit Masse 20 verbunden, wohingegen die Kathoden an hohem Potential liegen. Dadurch weisen die Kapazitätsdioden 4, 5, 7 eine sehr geringe Kapazität auf, so daß der Signalweg vom Eingang 1 zum Ausgang 2 eine hohe Signaldämpfung aufweist. Für die erreichbare Signaldämpfung bedeutsam ist insbesondere das Verhältnis der Impedanzen der gesperrten Kapazitätsdioden 4, 5 bzw. 7 zu den Impedanzen der leitenden Schalttransistoren 18 bzw. 19.

Werden dagegen die Schaltspannungen, d.h. die hohen Potentiale, an den Steueranschlüssen 12, 21 abgeschaltet, wird die Kopplung der Verbindungen der zweiten kapazitiven Schaltelemente innerhalb der Paare mit Masse unterbrochen. An den Verbindungen zwischen den einzelnen Paaren der zweiten kapazitiven Schaltelemente liegt dann ein niedriges Potential an. Werden die Steueranschlüsse 12, 21 nicht definiert auf ein niedriges Potential gelegt, sondern vielmehr potentialfrei geschaltet, stellen sich zwischen den Anoden und Kathoden der Kapazitätsdioden 4, 5, bzw. 7 (gegebenenfalls durch parasitäre Leckwiderstände) gegen Null strebende Potentialdifferenzen ein, so daß die Kapazitätsdioden 4, 5 bzw. 7 jetzt hohe Kapazitätswerte annehmen. Über diese und den Kondensator 6 erfolgt eine gute Signalkopplung vom Eingang 1 zum Ausgang 2.

Fig. 2 zeigt ein weiteres Ausführungsbeispiel für eine Schaltvorrichtung, wie sie bei der Erfindung zum Einsatz kommt, mit einer gegenüber Fig. 1 vergrößerten Signaldämpfung. Gegenüber dem Ausführungsbeispiel nach Fig. 1 ist im zweiten Paar zweiter kapazitiver Schaltelemente anstelle des Kondensators 6 eine vierte Kapazitätsdiode 24 getreten. Ein drittes Paar zweiter kapazitiver Schaltelemente wird durch zwei weitere Kondensatoren 25, 26 gebildet, die in die Reihenschaltung der bereits beschriebenen kapazitiven Schaltelemente eingefügt sind. Die (zweite) Verbindung 14 ist nun zwischen dem ersten Paar 4, 5 und dem dritten Paar 25, 26 angeordnet, eine (vierte) Verbindung 27 verbindte das dritte Paar 25, 26 mit dem abgewandelten zweiten Paar 24, 7. Von dieser Verbindung 27 ist ein vierter Vorwiderstand 28 an den ersten Steueranschluß 12 geführt. Eine (dritte) Verbindung 29 innerhalb des dritten Paares 25 ,26 ist über einen (dritten) Schalttransistor 30 mit Masse 20 verbunden. Dessen Basisanschluß ist über einen (dritten) Basiswiderstand 31 mit dem zweiten Steueranschluß 21 verbunden.

Durch das dritte Paar 25, 26 wird in Fig. 2 gegenüber Fig. 1 eine erhöhte Signaldämpfung durch den im gesperrten Zustand der Schaltvorrichtung über den Schalttransistor 30 zusätzlich ermöglichten Kurzschluß nach Masse 20 erhalten, ohne daß zusätzliche Kapazitätsdioden eingesetzt werden.

In weiteren Abwandlungen der beschriebenen Ausführungsbeispiele der Schaltvorrichtung können die Kondensatoren 25, 26 einzeln oder gleichmäßig durch Kapazitätsdioden ersetzt werden. Auch können weitere Paare zweiter kapazitiver Schaltelemente eingefügt werden. Zur Frequenzgangkompensation können am Eingang 1 und/oder am Ausgang 2 außerdem entsprechende Anpaßelemente angeordnet sein, die beispielsweise aus Induktivitäten, Kapazitäten und Widerstaänden gebildet sein können. Dadurch kann insbesondere das kapazitive Übertragungsverhalten der dargestellten Schaltvorrichtungen wenigstens teilweise ausgeglichen werden.

## Patentansprüche

1. Schaltungsanordnung zum Einspeisen eines Antennensignals an eine Empfangsanordnung eines Videorecorders und/oder einen an diesen angeschlossenen Fernsehempfänger mit einer Schaltvorrichtung, wobei im gesperrten Zustand der Schaltvorrichtung das Antennensignal nur der Empfangsanordnung des Videorecorders zuführbar und von dieser an den Fernsehempfänger weiterleitbar ist und im leitenden Zustand der Schaltvorrichtung das Antennensignal über diese unmittelbar dem Fernsehempfänger zuführbar ist,
dadurch gekennzeichnet, daß
- die Schaltvorrichtung eine Reihenschaltung aus nacheinander einem ersten kapazitiven Schaltelement mit konstanter Kapazität, wenigstens einem Paar zweiter kapazitiver Schaltelemente und einem dritten kapazitiven Schaltelement mit konstanter Kapazität enthält, wobei die zweiten kapazitiven Schaltelemente innerhalb der Paare zueinander in Reihe angeordnet sind, das erste kapazitive Schaltelement mit einem Eingang zum Zuführen des Antennensignals zur Schaltvorrichtung und das dritte kapazitive Schaltelement mit einem Ausgang zum Abgeben des Antennensignals von der Schaltvorrichtung verbunden ist,
- zum Überführen der Schaltvorrichtung in den gesperrten Zustand den Verbindungen der zweiten Schaltelemente innerhalb der Paare ein niedriges Potential und den Verbindungen der Paare untereinander bzw. mit dem ersten bzw. dritten kapazitiven Schaltelement ein hohes Potential zuleitbar ist,
- in wenigstens einem der Paare wenigstens eines der zweiten kapazitiven Schaltelemente eine konstante Kapazität aufweist und die übrigen zweiten kapazitiven Schaltelemente als Kapazitätsdioden ausgebildet sind, die mit ihren Anoden an die Verbindungen innerhalb der Paare und mit ihren Kathoden an die Verbindungen der Paare untereinander angeschlossen sind,
- und mit dem ersten und mit dem dritten kapazitiven Schaltelement je eines der als Kapazitätsdioden ausgebildeten zweiten kapazitiven Schaltelemente verbunden ist.

2. Schaltvorrichtung, die in ihrem gesperrten Zustand die Weiterleitung eines Antennensignals unterbricht und die Weiterleitung des Antennensignals in ihrem leitenden Zustand gestattet,
dadurch gekennzeichnet, daß
- die Schaltvorrichtung eine Reihenschaltung aus nacheinander einem ersten kapazitiven Schaltelement mit konstanter Kapazität, wenigstens einem Paar zweiter kapazitiver Schaltelemente und einem dritten kapazitiven Schaltelement mit konstanter Kapazität enthält, wobei die zweiten kapazitiven Schaltelemente innerhalb der Paare zueinander in Reihe angeordnet sind, das erste kapazitive Schaltelement mit einem Eingang zum Zuführen des Antennensignals zur Schaltvorrichtung und das dritte kapazitive Schaltelement mit einem Ausgang zum Abgeben des Antennensignals von der Schaltvorrichtung verbunden ist,
- zum Überführen der Schaltvorrichtung in den gesperrten Zustand den Verbindungen der zweiten Schaltelemente innerhalb der Paare ein niedriges Potential und den Verbindungen der Paare untereinander bzw. mit dem ersten bzw. dritten kapazitiven Schaltelement ein hohes Potential zuleitbar ist,
- in wenigstens einem der Paare wenigstens eines der zweiten kapazitiven Schaltelemente eine konstante Kapazität aufweist und die übrigen zweiten kapazitiven Schaltelemente als Kapazitätsdioden ausgebildet sind, die mit ihren Anoden an die Verbindungen innerhalb der Paare und mit ihren Kathoden an die Verbindungen der Paare untereinander angeschlossen sind,
- und mit dem ersten und mit dem dritten kapazitiven Schaltelement je eines der als Kapazitätsdioden ausgebildeten zweiten kapazitiven Schaltelemente verbunden ist.
